# FASCICULE DE BREVET EUROPEEN

(11) **EP 2 699 918 B1**
(45) Date de publication et mention de la délivrance du brevet: **15.04.2015**
(21) Numéro de dépôt: 12715392.2
(22) Date de dépôt: 19.04.2012
(51) Int. Cl.: G01R 33/04, G01C 17/28

(54) **VANNE DE FLUX ET PROCEDE DE FABRICATION D'UNE TELLE VANNE**
STRÖMUNGSVENTIL UND VERFAHREN ZUR HERSTELLUNG EINES SOLCHEN VENTILS
FLOW VALVE AND METHOD OF MANUFACTURING SUCH A VALVE

(30) Priorité: 22.04.2011 FR 1153511
(43) Date de publication de la demande: 26.02.2014
(73) Titulaire: SAGEM DEFENSE SECURITE, 92100 Boulogne Billancourt (FR)
(72) Inventeur: CARDOSO, Christian, F-75015 Paris (FR); HABERT, Didier, F-75015 Paris (FR); MERLET, Etienne, F-75015 Paris (FR); JEAN, Fabrice, F-75015 Paris (FR); MAGALHAES, Mickaël, F-75015 Paris (FR); PAUTARD, Sébastien, F-75015 Paris (FR)
(74) Mandataire: Lavialle, Bruno François Stéphane
(86) Numéro de dépôt international: PCT/EP2012/057184
(87) Numéro de publication internationale: WO 2012/143456

(56) Documents cités:
- FR-A1- 2 238 162
- FR-A5- 2 099 925

## Description

La présente invention concerne un dispositif à magnétomètres, et plus particulièrement une vanne de flux ou fluxgate en anglais. L'invention a également pour objet un procédé de fabrication d'une telle vanne.

Une vanne de flux est un dispositif de mesure du champ magnétique terrestre permettant de déterminer l'orientation du champ magnétique terrestre par rapport à un axe de référence.

Lorsque la vanne de flux est montée sur un aéronef, l'axe de référence est aligné avec l'axe de déplacement de l'aéronef de sorte que la vanne de flux permet de déterminer le cap magnétique de l'aéronef.

Une vanne de flux comporte deux magnétomètres uni-axiaux disposés perpendiculairement l'un à l'autre dans un plan sensiblement horizontal.

Chaque magnétomètre comprend un noyau en matériau à haute perméabilité magnétique choisi de telle manière que le champ magnétique terrestre suffise pour amener le noyau dans un état proche de son état de saturation. Les noyaux sont entourés par un enroulement primaire et par un enroulement secondaire. L'enroulement primaire est alimenté par un courant alternatif pour engendrer dans le noyau une variation de champ magnétique qui produit lui-même une différence de potentiels aux bornes de l'enroulement secondaire. Le traitement du signal qui apparaît sur l'enroulement secondaire permet la détermination très précise de la composante du champ magnétique dans la direction des bobines concernées.

Pour soustraire les magnétomètres à la composante verticale du champ magnétique terrestre, il est nécessaire de maintenir les magnétomètres dans un plan le plus horizontal possible. A cette fin les noyaux sont montés sur un pendule suspendu sous une platine. Le pendule est enfermé dans un boîtier qui est fixé à la platine et qui est rempli d'un liquide suffisamment visqueux pour amortir les mouvements du pendule.

Il en résulte que les vannes de flux du type connu sont relativement lourdes et encombrantes.

En outre, une baisse de la température entraîne un accroissement de la viscosité du liquide qui finit par empêcher le balancement du pendule. Ces vannes de flux se révèlent donc inutilisables en-dessous d'une certaine température, à savoir -20°C pour les plus performantes. Or, cette température est fréquemment atteinte sur certains aéronefs évoluant à haute altitude.

Les documents FR 2 238 162 et FR 2 099925 décrivent de telles vannes de flux.

Un but de l'invention est de fournir un moyen pour obvier au moins en partie aux inconvénients précités.

A cet effet, on prévoit, selon l'invention, une vanne de flux comprenant un boîtier contenant un ensemble électromagnétique de détection de champ magnétique, l'ensemble électromagnétique étant fixé à un pendule suspendu par une articulation à une paroi du boîtier, le boîtier contenant un liquide d'amortissement de mouvements du pendule, caractérisé en ce que le pendule comprend à l'opposé de l'articulation une surface qui a une forme de calotte sphérique et qui s'étend en regard d'une paroi du boîtier de forme complémentaire en définissant un espace ayant des dimensions adaptées pour produire un laminage du liquide d'amortissement entre elles lorsque le pendule est en mouvement.

Il est ainsi assuré un amortissement laminaire du pendule et non plus volumique comme par le passé. En effet, la forme de calotte sphérique de la surface du pendule et la complémentarité de la surface du pendule et de la paroi du boîtier en regard permettent très avantageusement de définir un espace régulier d'épaisseur constante entre ladite surface et ladite paroi. Le liquide présent dans cet espace forme ainsi un film d'épaisseur constante sur une très grande surface ce qui permet d'établir aisément un laminage du film lorsque le pendule est en mouvement.

Le document FR 2 238 162 décrit une vanne de flux dont la structure s'oppose à un amortissement laminaire. La figure 1 dudit document montre clairement que le pendule n'a pas une surface en forme de calotte sphérique et que la paroi du boîtier s'étendant en regard du pendule n'a pas une forme complémentaire de ladite surface. Cette paroi est en effet visiblement aplatie pour limiter le volume de la vanne de flux. L'irrégularité de l'espace délimité par la surface du pendule et la paroi du boîtier s'oppose donc à un laminage du liquide d'amortissement.

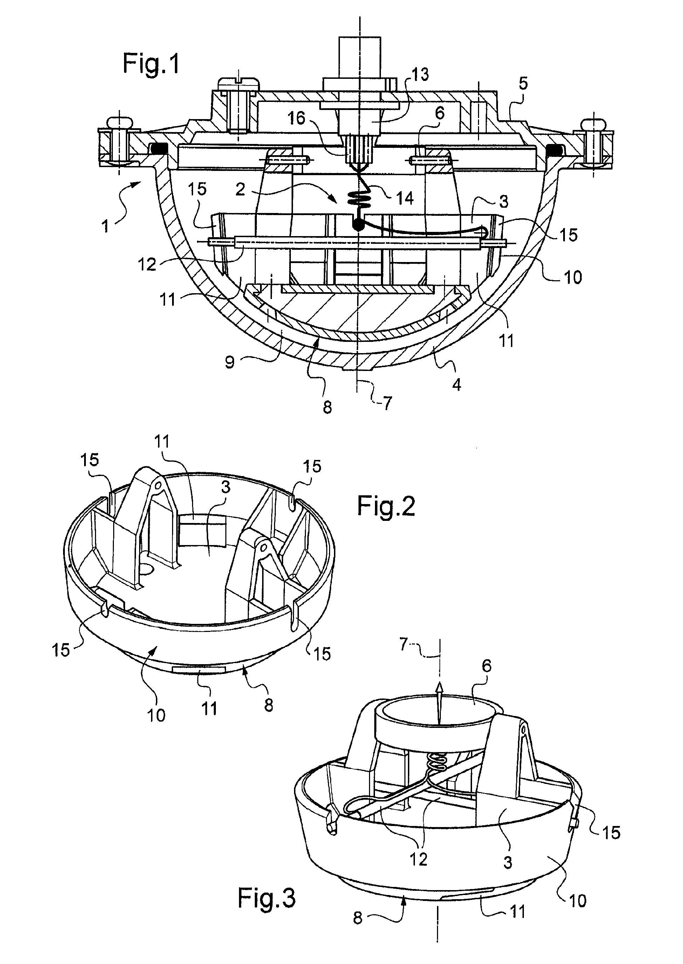

De la même façon, le document FR 2 099925 décrit une vanne de flux dont la structure s'oppose à un amortissement laminaire puisque, comme visible à la figure 1, la vanne de flux comporte une plaque de cognement annulaire qui crée des turbulences à la frontière de l'espace délimité par la paroi du boîtier et par la surface du pendule en regard, ce qui interdit toute possibilité de laminage du liquide d'amortissement.

Au contraire, grâce à l'invention, l'amortissement laminaire du pendule est possible et permet de :
- limiter la quantité de liquide d'amortissement nécessaire de sorte que la vanne de flux est relativement compacte et légère ;
- d'utiliser un liquide d'amortissement ayant une viscosité plus faible permettant son emploi, en pleine performance, à des températures plus basses jusqu'à -50°C voire en deçà ;
- d'utiliser un liquide d'amortissement moins dense et moins sensible aux variations de températures.

Avantageusement ladite surface du pendule est bordée par une portion de surface en retrait pour favoriser une entrée du liquide d'amortissement dans l'espace et, de préférence, la portion de surface en retrait a une forme tronconique.

Il est ainsi créé un effet d'entonnoir qui facilite voire force la pénétration du liquide d'amortissement dans l'espace dédié au laminage du liquide d'amortissement.

Avantageusement, ladite surface du pendule est percée d'ouvertures d'échappement du liquide d'amortissement au voisinage de son pourtour.

Les ouvertures d'échappement permettent de limiter le risque d'une accélération du liquide d'amortissement lors de sa pénétration dans l'espace de laminage. Une telle accélération serait préjudiciable au contrôle de l'amortissement procuré par le liquide d'amortissement.

L'invention a également pour objet un procédé de fabrication d'une vanne de flux dans laquelle l'ensemble électromagnétique de détection comprend deux magnétomètres uni-axiaux disposés perpendiculairement l'un à l'autre et ayant des portions d'extrémité reçues dans des encoches ménagées dans le pendule, le boîtier comportant une platine de fixation à laquelle est suspendu le pendule. Le procédé comporte l'étape de suspendre le pendule à la platine de fixation et une phase de mise en place des magnétomètres comportant trois étapes :
- positionner la platine horizontalement et laisser le pendule penduler jusqu'à ce qu'il se stabilise,
- positionner les extrémités des magnétomètres dans les encoches du pendule tout en maintenant dans une position horizontale les deux magnétomètres et, sans toucher le pendule,
- déposer une goutte de colle simultanément dans les quatre encoches et faire polymériser la colle.

D'autres caractéristiques et avantages de l'invention ressortiront à la lecture de la description qui suit d'un mode de réalisation particulier non limitatif de l'invention.

Il sera fait référence aux dessins annexés, parmi lesquels :
- la figure 1 est une vue en coupe axiale d'une vanne de flux conforme à l'invention,
- la figure 2 est une vue en perspective du pendule de cette vanne, avant mise en place des magnétomètres,
- la figure 3 est une vue en perspective du pendule une fois équipé des magnétomètres.

En référence aux figures, la vanne de flux comprend un boîtier, généralement désigné en 1, contenant un ensemble électromagnétique 2 de détection de champ magnétique et un pendule 3 qui est suspendu dans le boîtier et supporte l'ensemble électromagnétique 2.

Le boîtier 1 comprend une paroi 4 en forme de calotte sphérique ayant un bord circulaire délimitant une ouverture obturée par une platine 5 de fixation de la vanne à un support.

Le pendule 3 est suspendu à la platine 5 par une articulation double 6 comportant un anneau relié à la platine 5 pour pivoter autour d'un premier axe et relié au pendule 3 pour pivoter autour d'un deuxième axe perpendiculaire au premier axe et coplanaire à celui-ci. Les moyens de liaison de l'anneau à la platine 5 comprennent deux liaisons pivots à centrage court et les moyens de liaison de l'anneau au pendule 3 comprennent également deux liaisons pivots à centrage court. Pour chaque axe, chaque liaison pivot comprend un tourillon ayant une extrémité encastrée dans le pendule ou la platine et une extrémité opposée reçue librement via un ajustement glissant dans un perçage réalisé dans l'anneau. La portée de l'ajustement est réduite au maximum pour éviter qu'une déformation des pièces induisant un désalignement des tourillons n'engendre des contraintes préjudiciables au mouvement du pendule. En variante, les liaisons pivots peuvent être remplacées par des liaisons rotules pour limiter encore les contraintes qui pourraient résulter d'un mauvais alignement des tourillons, cette variante étant cependant plus coûteuse. L'articulation double 6 autorise un débattement angulaire du pendule 5 de 30° environ de part et d'autre d'un troisième axe normal à la platine et sécant du premier axe et du deuxième axe.

Le pendule 3 incorpore une masse équilibrée de telle manière qu'au repos, la platine étant horizontale, un axe 7 passant par le centre de gravité du pendule et l'intersection des axes de pivotement du pendule 3 soit normal à la platine 5.

Le pendule 3 comprend en regard de la paroi 4 une surface 8 en calotte sphérique centrée sur l'axe 7. La surface 8 délimite avec la paroi 4 un espace de laminage 9. La surface 8 est entourée d'une portion annulaire de surface 10 en retrait et est percée, au voisinage de son pourtour, d'ouvertures 11 traversantes.

De préférence, le pendule est réalisé en matériau thermoplastique, ici non chargé pour favoriser la précision et la stabilité géométrique en température des surfaces sphériques, et incorpore un insert, par exemple en métal, formant une masse inertielle. Le pendule est avantageusement fabriqué dans ce cas par injection du matériau thermoplastique dans un moule de manière à surmouler le matériau thermoplastique sur l'insert. Ce mode de fabrication permet de : limiter les opérations d'assemblage ; obtenir un pendule présentant une surface extérieure relativement lisse favorable à la réalisation de l'amortissement laminaire ; optimiser le positionnement relatif du centre d'inertie du pendule, du centre de rotation du pendule et du centre de la calotte. Le matériau thermoplastique choisi est par exemple un polyéther imide (PEI).

L'ensemble électromagnétique 2 comprend des magnétomètres 12 uni-axiaux, connus en eux-mêmes, comprenant des noyaux en un matériau ferromagnétique ayant une haute perméabilité magnétique et réagissant aux champs magnétiques de faible intensité. Le matériau ferromagnétique employé ici est plus particulièrement un alliage de fer et de nickel, ayant une perméabilité très élevée, préférentiellement supérieure à 1.10⁻² H/m. Chaque noyau comprend ici des bandes dudit matériau qui sont fixées dans un tube de verre.

Deux enroulements superposés entourent le tube de verre, l'enroulement primaire et l'enroulement secondaire du magnétomètre.

Les magnétomètres 12 s'étendent à 90° l'un par rapport à l'autre et l'un au-dessus de l'autre parallèlement au premier axe et au deuxième axe de l'articulation double 6. Les magnétomètres 12 sont écartés l'un de l'autre pour éviter un couplage magnétique entre eux. Les magnétomètres 12 ont leurs extrémités fixées dans des encoches périphériques 15 du pendule 3 de telle manière que, lorsque le pendule 3 est laissé libre de penduler et au repos, les magnétomètres 12 soient horizontaux.

Les enroulements sont reliés à un connecteur 13 monté au centre de la platine 5. Le connecteur 13 est par exemple un connecteur de type micro connecteur cylindrique étanche à 5 broches. Les fils reliant les enroulements au connecteur 13 sont torsadés et maintenus ensemble au moyen d'une goutte de colle déposée au point où les fils divergent pour rejoindre les enroulements. La torsade 14 ainsi formée est conformée de telle manière que la torsade 14 n'entrave pas les mouvements du pendule. La torsade 14 est ici conformée en une queue de cochon à deux spires. La torsade 14 ainsi conformée est disposée pour s'étendre sensiblement autour de l'axe 7, le pendule 3 étant au repos et la platine 5 horizontale, de manière à minimiser son influence sur le balancement du pendule 3. En variante, la torsade peut être conformée en une autre forme spiralée, par exemple plane. En variante encore, la torsade 14 peut être conformée pour suivre les axes de rotation de l'articulation double 6, toujours de manière que son influence sur les mouvements du pendule soit minimisée.

La torsade 14 a une portion d'extrémité noyée dans un bloc de résine 16 qui est solidaire du connecteur 13 et qui emprisonne également la zone de connexion des fils aux broches du connecteur 13. Le bloc de résine 16 permet d'augmenter la résistance mécanique de la liaison des fils au connecteur 13 et plus généralement d'éviter qu'un effort de traction exercé sur la torsade engendre une contrainte importante sur les fils individuellement ou sur leur liaison au connecteur.

Un liquide d'amortissement emplit une partie du boîtier 1, ici jusqu'au bord supérieur du pendule 3.

L'espace de laminage 9 reçoit ainsi du liquide d'amortissement de telle manière que le liquide d'amortissement soit laminé entre la surface 8 et la paroi 4. La portion annulaire de surface en retrait 10 définit avec la paroi 4 un genre d'entonnoir favorisant la pénétration du liquide d'amortissement dans l'espace de laminage 9.

Le rayon du pendule 3 et de la surface interne de la paroi 4 du boîtier 1 définissant l'épaisseur de l'espace de laminage 9 sont déterminés en appliquant par exemple la théorie du viscosimètre de Couette.

Certaines étapes de la fabrication de la vanne de flux doivent être réalisées avec précaution.

La mise en place des magnétomètres 12 doit être réalisée avec beaucoup de précision et comprend trois étapes :
- positionner la platine 5 horizontalement et laisser le pendule 3 penduler jusqu'à ce qu'il se stabilise,
- positionner les extrémités des magnétomètres 12 dans les encoches du pendule 3 tout en maintenant dans une position horizontale les deux magnétomètres et, sans toucher le pendule 3,
- déposer une goutte de colle (la colle utilisée est une colle très fluide) simultanément dans les quatre encoches et faire polymériser la colle.

Ce mode de fabrication est particulièrement indiqué ici car il permet de s'affranchir des organes de réglage autrement nécessaires pour positionner horizontalement et fixer les magnétomètres. Or, de tels organes de réglage pourraient altérer le caractère laminaire de l'amortissement et constituent des éléments massifs déportés par rapport au centre de gravité du pendule. En outre, la suppression des organes de réglage rend la vanne de flux plus précis et robuste avec un risque de dérèglement dans le temps extrêmement limité.

Le liquide d'amortissement retenu est une huile ayant une viscosité cinématique de 5 mm²/s à 25°C, une densité voisine de 0,91 à 25°C, un point de congélation à-65°C.

L'épaisseur de l'espace de laminage 9 résulte d'un compromis tenant compte de la viscosité du liquide d'amortissement et du procédé de fabrication choisi. En effet, dans l'hypothèse où une fabrication en matériaux thermoplastiques injectés est choisi, l'épaisseur minimale qu'il est possible d'obtenir dépendra de la réalisation ou non d'une reprise d'usinage.

Bien entendu, l'invention n'est pas limitée au mode de réalisation décrit mais englobe toute variante entrant dans le champ de l'invention telle que définie par les revendications.

En particulier, le boîtier et le pendule peuvent avoir une structure différente de celle décrite. Le boîtier peut avoir une forme extérieure différente de sa forme intérieure en calotte sphérique.

L'ensemble électromagnétique peut avoir une structure différente et comprendre un tore.

D'autres liquides d'amortissement peuvent être choisis avec des valeurs voisines de celles mentionnées.

## Revendications

1. Vanne de flux comprenant un boîtier (1) contenant un ensemble électromagnétique (2) de détection de champ magnétique, l'ensemble électromagnétique étant fixé à un pendule (3) suspendu par une articulation (6) à une paroi (5) du boîtier, le boîtier contenant un liquide d'amortissement de mouvements du pendule, **caractérisé en ce que** le pendule comprend à l'opposé de l'articulation une surface (8) qui a une forme de calotte sphérique et qui s'étend en regard d'une paroi (4) du boîtier de forme complémentaire en définissant un espace ayant des dimensions adaptées pour produire un laminage du liquide d'amortissement entre elles lorsque le pendule est en mouvement.

2. Vanne selon la revendication 1, dans lequel ladite surface (8) du pendule (3) est bordée par une portion de surface en retrait (10) pour favoriser une entrée du liquide d'amortissement dans l'espace (9).

3. Vanne selon la revendication 2, dans lequel la portion de surface en retrait (10) a une forme tronconique.

4. Vanne selon la revendication 1, dans lequel ladite surface (8) du pendule (3) est percée d'ouvertures (11) d'échappement du liquide d'amortissement au voisinage de son pourtour.

5. Vanne selon la revendication 1, dans lequel l'ensemble électromagnétique de détection (2) comprend deux magnétomètres (12) uni-axiaux disposés perpendiculairement l'un à l'autre.

6. Vanne selon la revendication 5, dans lequel les magnétomètres (12) ont des portions d'extrémité reçues dans des encoches (15) ménagées dans le pendule (3).

7. Vanne selon la revendication 1, dans lequel l'ensemble magnétométrique (2) est relié à un connecteur (13), monté sur la platine (5), par des fils rassemblés en une torsade (14).

8. Vanne selon la revendication 7, dans lequel la torsade (14) est conformée en forme spiralée d'axe sensiblement normal à la platine (5).

9. Vanne selon la revendication 7, dans lequel la torsade (14) est conformée pour suivre sensiblement les axes de rotation de l'articulation double (6).

10. Vanne selon la revendication 7, dans lequel les connexions des fils au connecteur (13) sont noyées dans un bloc de résine (16) solidaire du connecteur.

11. Vanne selon la revendication 7, dans lequel la torsade (14) a une portion d'extrémité noyée dans le bloc de résine (16).

12. Vanne selon la revendication 1, dans lequel le pendule est réalisé en matériau thermoplastique et incorpore un insert formant une masse inertielle.

13. Vanne selon la revendication 12, dans lequel le pendule est obtenu par surmoulage du matériau thermoplastique autour de l'insert.

14. Vanne selon la revendication 1, dans lequel le liquide d'amortissement retenu a une viscosité cinématique d'environ 5 mm²/s à 25°C, une densité voisine de 0,91 à 25°C, et un point de congélation à -65°C environ.

15. Vanne selon la revendication 1, dans laquelle l'articulation (6) est reliée à la paroi (5) et au pendule (3) par des moyens de liaison agencés pour autoriser un débattement du pendule (3) autour de deux axes et les moyens de liaison comprennent deux liaisons pivot pour chaque axe.

16. Procédé de fabrication d'une vanne de flux conforme à l'une quelconque des revendications précédentes et dans laquelle l'ensemble électromagnétique de détection (2) comprend deux magnétomètres (12) uni-axiaux disposés perpendiculairement l'un à l'autre et ayant des portions d'extrémité reçues dans des encoches (15) ménagées dans le pendule (3), le boîtier comportant une platine de fixation à laquelle est suspendu le pendule, le procédé comportant l'étape de suspendre le pendule à la platine de fixation et une phase de mise en place des magnétomètres (12) comportant trois étapes :
- positionner la platine (5) horizontalement et laisser le pendule (3) penduler jusqu'à ce qu'il se stabilise,
- positionner les extrémités des magnétomètres (12) dans les encoches du pendule (3) tout en maintenant dans une position horizontale les deux magnétomètres et, sans toucher le pendule (3),
- déposer une goutte de colle simultanément dans les quatre encoches et faire polymériser la colle.

## Patentansprüche

1. Fluxgate-Sonde, umfassend ein Gehäuse (1), das eine elektromagnetische Einheit (2) zur Magnetfelderfassung enthält, wobei die elektromagnetische Einheit an einem Pendel (3) befestigt ist, das über eine Gelenkverbindung (6) an einer Wand (5) des Gehäuses aufgehängt ist, wobei das Gehäuse eine Dämpfungsflüssigkeit zur Dämpfung der Bewegungen des Pendels enthält, **dadurch gekennzeichnet, dass** das Pendel entgegengesetzt zur Gelenkverbindung eine Oberfläche (8) umfasst, die eine Kugelkappenform hat und sich gegenüber einer Wand (4) des Gehäuses mit komplementärer Form erstreckt und dabei einen Zwischenraum definiert, der Abmessungen hat, die dazu geeignet sind, eine laminare Strömung der Dämpfungsflüssigkeit zwischen ihnen zu erzeugen, wenn das Pendel in Bewegung ist.

2. Sonde nach Anspruch 1, wobei die genannte Oberfläche (8) des Pendels (3) von einem zurückgesetzten Oberflächenabschnitt (10) eingefasst ist, um einen Eintritt der Dämpfungsflüssigkeit in den Zwischenraum (9) zu begünstigen.

3. Sonde nach Anspruch 2, wobei der zurückgesetzte Oberflächenabschnitt (10) eine Kegelstumpfform hat.

4. Sonde nach Anspruch 1, wobei die genannte Oberfläche (8) des Pendels (3) nahe ihrem Umfang von Öffnungen (11) zum Austritt der Dämpfungsflüssigkeit durchsetzt ist.

5. Sonde nach Anspruch 1, wobei die elektromagnetische Erfasssungseinheit (2) zwei einaxiale Magnetometer (12) umfasst, die senkrecht zueinander angeordnet sind.

6. Sonde nach Anspruch 5, wobei die Magnetometer (12) Endabschnitte haben, die in in dem Pendel (3) ausgebildeten Auskerbungen (15) aufgenommen sind.

7. Sonde nach Anspruch 1, wobei die elektromagnetische Einheit (2) über zu einem verdrillten Leiter (14) zusammengefasste Drähte mit einem auf der Platte (5) montierten Verbinder (13) verbunden ist.

8. Sonde nach Anspruch 7, wobei der verdrillte Leiter (14) spiralförmig ausgebildet ist, mit einer Achse, die im Wesentlichen senkrecht zur Platte (5) ist.

9. Sonde nach Anspruch 7, wobei der verdrillte Leiter (14) derart ausgebildet ist, dass er im Wesentlichen den Drehachsen der doppelten Gelenkverbindung (6) folgt.

10. Sonde nach Anspruch 7, wobei die Verbindungen der Drähte am Verbinder (13) in einen mit dem Verbinder verbundenen Harzblock (16) eingebettet sind.

11. Sonde nach Anspruch 7, wobei der verdrillte Leiter (14) einen Endabschnitt hat, der in den Harzblock (16) eingebettet ist.

12. Sonde nach Anspruch 1, wobei das Pendel aus einem thermoplastischen Material hergestellt ist und einen Einsatz einschließt, der eine träge Masse bildet.

13. Sonde nach Anspruch 12, wobei das Pendel durch Umformen des Einsatzes mit thermoplastischem Material erhalten wird.

14. Sonde nach Anspruch 1, wobei die in Betracht gezogene Dämpfungsflüssigkeit eine kinematische Viskosität von ungefähr 5 mm²/s bei 25°C, eine Dichte nahe 0,91 bei 25°C und einen Gefrierpunkt bei ungefähr -65°C hat.

15. Sonde nach Anspruch 1, wobei die Gelenkverbindung (6) mit der Wand (5) und dem Pendel (3) über Verbindungsmittel verbunden ist, die derart ausgebildet sind, dass sie eine Auslenkung des Pendels (3) um zwei Achsen gestatten, und die Verbindungsmittel zwei Schwenkverbindungen für jede Achse umfassen.

16. Verfahren zum Herstellen einer Fluxgate-Sonde gemäß einem der vorhergehenden Ansprüche und wobei die elektromagnetische Erfassungseinheit (2) zwei einaxiale Magnetometer (12) umfasst, die senkrecht zueinander angeordnet sind und Endabschnitte haben, die in in dem Pendel (3) ausgebildeten Auskerbungen (15) aufgenommen sind, wobei das Gehäuse eine Befestigungsplatte umfasst, an der das Pendel aufgehängt ist, wobei das Verfahren den Schritt des Aufhängens des Pendels an der Befestigungsplatte und eine Phase des Platzierens der Magnetometer (12) umfasst, die drei Stufen umfasst:
- horizontales Positionieren der Platte (5) und Schwingen lassen des Pendels, bis es sich stabilisiert hat,
- Positionieren der Enden der Magnetometer (12) in den Auskerbungen des Pendels (3), während man die zwei Magnetometer in einer horizontalen Position hält und ohne Berühren des Pendels (3),
- gleichzeitiges Auftragen eines Tropfens Klebstoff in die vier Auskerbungen und Polymerisieren lassen des Klebstoffs.

## Claims

1. A fluxgate comprising a casing (1) containing an electromagnetic assembly (2) for detecting a magnetic field, wherein the electromagnetic assembly is attached to a pendulum (3) suspended from a wall (5) of the casing by an articulation (6), wherein the casing contains a liquid for damping the movements of the pendulum, **characterized in that** the pendulum comprises, at the opposite end from the articulation, a surface (8) which is in the shape of a spherical cap and extends facing a wall (4) of the casing that has a form complementary to the form of the surface (8), defining a space having suitable dimensions to laminate the damping liquid between the surface and the wall when the pendulum moves.

2. The fluxgate as claimed in claim 1, wherein said surface (8) of the pendulum (3) is bounded by a recessed surface portion (10) in order to facilitate the entry of the damping liquid into the space (9).

3. The fluxgate as claimed in claim 2, wherein the shape of the recessed surface portion (10) is frustoconical.

4. The fluxgate as claimed in claim 1, wherein said surface (8) of the pendulum (3) features, adjacent to its periphery, openings (11) through which the damping liquid can escape.

5. The fluxgate as claimed in claim 1, wherein the electromagnetic detection assembly (2) comprises two uniaxial magnetometers (12) arranged perpendicular to one another.

6. The fluxgate as claimed in claim 5, wherein the magnetometers (12) have end portions received in notches (15) created in the pendulum (3).

7. The fluxgate as claimed in claim 1, wherein the magnetometer assembly (2) is connected to a connector (13), mounted on the plate (5), by wires gathered together in a twist (14).

8. The fluxgate as claimed in claim 7, wherein the twist (14) is in a spiral shape the axis of which is substantially normal to the plate (5).

9. The fluxgate as claimed in claim 7, wherein the twist (14) is shaped so as to substantially follow the axes of rotation of the double articulation (6).

10. The fluxgate as claimed in claim 7, wherein the connections between the wires and the connector (13) are embedded in a block of resin (16) which is secured to the connector.

11. The fluxgate as claimed in claim 7, wherein the twist (14) has an end portion which is embedded in the block of resin (16).

12. The fluxgate as claimed in claim 1, wherein the pendulum is made of a thermoplastic material and incorporates an insert forming an inertial mass.

13. The fluxgate as claimed in claim 12, wherein the pendulum is obtained by overmolding the thermoplastic material about the insert.

14. The fluxgate as claimed in claim 1, wherein the selected damping liquid has a kinematic viscosity of approximately 5 mm²/s at 25°C, a density of around 0.91 at 25°C and a freezing point of circa -65°C.

15. The fluxgate as claimed in claim 1, wherein the articulation (6) is connected to the wall (5) and to the pendulum (3) by connection means arranged so as to allow the pendulum (3) to move about two axes and the connection means comprise two pivot connections for each axis.

16. A method for manufacturing a fluxgate in accordance with any one of the preceding claims, wherein the electromagnetic detection assembly (2) comprises two uniaxial magnetometers (12) arranged perpendicular to one another and having end portions received in notches (15) created in the pendulum (3), wherein the casing comprises an attachment plate from which the pendulum is suspended, the method involving the step of suspending the pendulum from the attachment plate and a stage of installing the magnetometers (12) consisting of three steps:
- positioning the plate (5) horizontally and allowing the pendulum (3) to swing until it is stable,
- positioning the ends of the magnetometers (12) in the notches of the pendulum (3) while keeping the two magnetometers in a horizontal position and, without touching the pendulum (3),
- placing a drop of adhesive simultaneously in the four notches and polymerizing the adhesive.
